Europäisches Patentamt

European Patent Office

Office européen des brevets

(19)

(11) Veröffentlichungsnummer: **0 124 168**
**B1**

(12) **EUROPÄISCHE PATENTSCHRIFT**

(45) Veröffentlichungstag der Patentschrift:
29.11.89

(51) Int. Cl.⁴: **H 03 D 9/06**

(21) Anmeldenummer: **84200565.4**

(22) Anmeldetag: **19.04.84**

(54) **Mischer.**

(30) Priorität: **30.04.83 DE 3315860**

(43) Veröffentlichungstag der Anmeldung:
**07.11.84 Patentblatt 84/45**

(45) Bekanntmachung des Hinweises auf die Patenterteilung:
**29.11.89 Patentblatt 89/48**

(84) Benannte Vertragsstaaten:
**DE FR GB IT**

(56) Entgegenhaltungen:
**DE-A- 3 014 966**
**GB-A- 1 493 381**
**US-A- 3 652 941**
**US-A- 3 678 395**
**US-A- 4 000 469**
**US-A- 4 032 849**

**13th EUROPEAN MICROWAVE CONFERENCE,
5.-8.September 1983, Nürnberg, DE, Seiten 567-572,
Microwave Exhibitions and Publishers Ltd., Turnbridge
Wells, Kent, GB; R. KNOECHEL: "A double balanced
finline mixer with broad if bandwidth capaability",
Seiten 567-572**

(73) Patentinhaber: **Philips Patentverwaltung GmbH,
Wendenstrasse 35 Postfach 10 51 49,
D-2000 Hamburg 1 (DE)**

(84) Benannte Vertragsstaaten: **DE**

(73) Patentinhaber: **N.V. Philips' Gloeilampenfabrieken,
Groenewoudseweg 1, NL-5621 BA Eindhoven (NL)**

(84) Benannte Vertragsstaaten: **FR GB IT**

(72) Erfinder: **Knöchel, Reinhard, Dr., Alte Eiche 8,
D-2200 Kölln-Reisiek (DE)**

(74) Vertreter: **Hartmann, Heinrich, Dipl.-Ing. et al, Philips
Patentverwaltung GmbH
Wendenstrasse 35 Postfach 10 51 49,
D-2000 Hamburg 1 (DE)**

Anmerkung: Innerhalb von neun Monaten nach der Bekanntmachung des Hinweises auf die Erteilung des europäischen
Patents im Europäischen Patentblatt kann jedermann beim Europäischen Patentamt gegen das erteilte europäische Patent
Einspruch einlegen. Der Einspruch ist schriftlich einzureichen und zu begründen. Er gilt erst als eingelegt, wenn die
Einspruchsgebühr entrichtet worden ist (Art. 99(1) Europäisches Patentübereinkommen).

ACTORUM AG

## Beschreibung

Die Erfindung bezieht sich auf einen Mischer, insbesondere zum Betrieb im Mikrowellen- und Millimeterwellenbereich, mit vier im wesentlichen einen Ring bildenden, zweipoligen Mischelementen, die im Bereich einer Übergangsstelle wenigstens zweier Wellenleiter angeordnet sind, von denen ein erster eine schlitzförmige und ein zweiter eine aus wenigstens einem mittleren und darum herum angeordneten äußeren Leiterteilen bestehende Leiterstruktur umfaßt, von der zumindest die Leiterteile des ersten Wellenleiters und das mittlere Leiterteil des zweiten Wellenleiters als Beläge auf der Oberseite eines plattenförmigen Trägers aus dielektrischem Material angeordnet sind.

Aus der US-A-3 678 395 ist ein Mischer bekannt, bei dem vier ringförmig zusammengeschaltete Mischerdioden an der Verbindungsstelle eines Schlitzleiters mit einem axial dazu verlaufenden koplanaren Leiter angeordnet sind. Über die Schlitzleitung und die koplanare Leitung werden den Dioden hochfrequente elektromagnetische Wellen zugeführt. Die als Mischprodukt dieser Wellen an den Dioden gebildeten elektromagnetischen Schwingungen werden über ein Ableitungsnetzwerk aus induktiven Leitern und Kondensatoren sowie ein Transformationsnetzwerk von den Dioden abgeleitet und als Zwischenfrequenzsignal einem Zwischenfrequenzausgang zugeführt.

Der bekannte Mischer weist den Nachteil auf, daß zusätzlich zu der Schlitzleitung und der koplanaren Leitung komplizierte Bauteile zum Ableiten der Mischprodukte an den Zwischenfrequenzausgang erforderlich sind. Diese Bauteile, wie Drähte, Kondensatoren oder Transformationsnetzwerke, werden bei der Herstellung der Mischer in gesonderten Arbeitsgängen, beispielsweise durch Löten, mit den Leitungen verbunden und verursachen dadurch einen hohen Fertigungsaufwand. Darüber hinaus wird durch derartige Schaltungsbestandteile der Frequenzbereich für die dem Mischer zugeführten elektromagnetischen Wellen begrenzt, insbesondere wird der Frequenzbereich für die Mischprodukte zu hohen Frequenzen hin stark eingeschränkt. Ferner sind die genannten zusätzlichen Schaltelemente wenigstens teilweise in der Herstellung schwer reproduzierbar, wodurch zwischen einzelnen gefertigten Mischern große Streuungen der elektrischen Eigenschaften auftreten können. Auch ist ein in der beschriebenen Weise aufgebauter Mischer empfindlich gegen mechanische Beanspruchungen.

Die Erfindung hat die Aufgabe, einen Mischer zu schaffen, der einfach und robust aufgebaut ist und bei guter Reproduzierbarkeit seiner elektrischen Eigenschaften kostengünstig gefertigt werden kann. Es ist weiterhin Aufgabe der Erfindung, einen Mischer für einen großen Frequenzbereich zu schaffen.

Diese Aufgabe wird bei einem planaren Mischer der eingangs genannten Art dadurch gelöst, daß der Träger auf seiner Unterseite mit leitenden Belägen versehen ist, die wenigstens nahezu übereinstimmend mit den Belägen auf der Oberseite geformt und zumindest im wesentlichen deckungsgleich dazu angeordnet sind, daß jeder der beiden Wellenleiter die zu den Belägen auf der Oberseite deckungsgleich angeordneten Beläge auf der Unterseite des Trägers mit umfaßt, daß ein dritter Wellenleiter aus den Belägen auf der Ober- und Unterseite gebildet wird, die die mittleren Leiterteile des zweiten Wellenleiters bilden, und daß jeweils zwei der Mischelemente auf jeder Seite des Trägers je einen der mittleren Beläge mit je einem der Teile der übrigen Beläge verbindend angeordnet sind.

Der Erfindung liegt das Prinzip zugrunde, einen Mischer derart auszubilden, daß die Mischelemente an der Übergangsstelle dreier Wellenleiter angeordnet sind. Die auf den drei Wellenleitern geführten elektromagnetischen Wellen weisen dabei überwiegend «orthogonale» Feldbilder auf, das bedeutet, daß an der Übergangsstelle der Wellenleiter ohne die Mischelemente überwiegend keine Ausbreitung der elektromagnetischen Wellen des einen Wellenleiters auf einem anderen erfolgt. Für Wellen, die auf den Wellenleitern in Richtung auf die Übergangsstelle einfallen, bildet diese Übergangsstelle im wesentlichen einen Leerlauf. Es sind daher im wesentlichen keine zusätzlichen Entkopplungs- oder Filternetzwerke zum Trennen der sich auf den einzelnen Wellenleitern ausbreitenden Wellen erforderlich. Auch können die Mischelemente räumlich dicht beieinander angeordnet werden.

Die genannte Orthogonalität der Feldbilder gilt mit einer Einschränkung: Die auf den ersten, schlitzförmigen Wellenleiter auf die Übergangsstelle zwischen dem ersten und dem zweiten Wellenleiter zulaufende Welle ist auch als besondere Wellenform auf dem zweiten Wellenleiter ausbreitungsfähig. Diese Überkopplung der Welle vom ersten Wellenleiter auf den zweiten Wellenleiter ermöglicht es einerseits, die Mischelemente wahlweise je nach der räumlich günstigsten Ausgestaltung entweder mit den Teilen der Beläge des ersten Wellenleiters oder den äußeren Teilen der Beläge des zweiten Wellenleiters zu verbinden. Andererseits zeigt sich, daß die Ausbreitung der aus dem ersten Wellenleiter übergekoppelten Wellenform auf dem zweiten Wellenleiter durch sehr einfache, im nachstehenden noch beschriebenen Maßnahmen unterbunden werden kann.

Der erfindungsgemäße Mischer bietet somit den Vorteil einer einfachen, kompakten, leichten und robusten Bauweise. Die Leiterstrukturen sind beispielsweise durch photolithographische Verfahren einfach herstellbar und können mit hoher Genauigkeit reproduziert werden. Auf dieser Leiterstruktur werden dann nur noch die Mischelemente in einfacher Weise, z. B. durch Löten, befestigt. Um einen Ring mit einer symmetrischen Anordnung der Mischelemente zu erhalten, werden jeweils zwei Mischelemente auf jeder Seite des Trägers angeordnet. Insbesondere verbinden die Mischelemente dabei auf jeder Seite des Trägers jeweils den mittleren Belag des zweiten Wellenleiters mit den beidseitig des Schliztes befindlichen Teilen der Beläge des ersten Wellenleiters. Der durch die Mischelemente gebildete Ring wird über die Kapazitäten zwischen den auf den beiden Seiten des Trägers einander gegenüberliegenden leitenden Belägen insbesondere des ersten Wellenleiters geschlossen.

An dieser Stelle sei bemerkt, daß es aus der DE-A-3 014 966 im Prinzip bekannt ist, bei einem Mikrowellen- und Millimeterwellenmischer ein Trägersubstrat zweiseitig zu metallisieren.

Nach einer vorteilhaften Ausgestaltung der Erfindung sind die die Leiterteile des ersten Wellenleiters bildenden Teile der Beläge und die auf der jeweils gleichen Seite des dielektrischen Trägers benachbart angeordneten äußeren Teile der Beläge des zweiten Wellenleiters einstückig ausgebildet. Dadurch wird eine einfache Gestaltung der Wellenleiter und eine gute galvanische Verbindung der aneinander anschließenden Teile der Wellenleiter erreicht. Es ist auch möglich, daß die genannten Beläge ohne Änderungen ihrer quer zur Ausbreitungsrichtung der Wellen liegenden Abmessungen ineinander übergehen. Der zweite Wellenleiter unterscheidet sich vom ersten Wellenleiter dann nur dadurch, daß zwischen die äußeren Teile der Beläge mittlere Beläge eingefügt sind. Die im einzelnen festzulegenden Abstände zwischen einzelnen Teilen der Beläge eines Wellenleiters auf jeweils einer Seite des Trägers werden durch die erwünschten Wellenwiderstände der Wellenleiter bestimmt.

Nach einer vorteilhaften Weiterbildung der Erfindung ist der Träger aus dielektrischem Material in einem elektrisch leitenden Gehäuse angeordnet. Dadurch wird der Mischer gegen elektromagnetische Störungen abgeschirmt und ein mechanisch stabiler Aufbau erhalten.

Nach einer anderen Weiterbildung der Erfindung ist der erste Wellenleiter als Schlitz- bzw. Flossenleitung und der zweite Wellenleiter als koplanare Leitung ausgebildet. Der dritte Wellenleiter ist als Parallelplattenleitung ausgebildet. Diese drei Wellenleiterformen lassen sich in einfacher Weise aus leitenden Belägen eines plattenförmigen dielektrischen Trägers bilden. Die genannte Zuordnung der drei Wellenleitertypen zu dem ersten, zweiten und dritten Wellenleiter führt auf eine besonders einfache und kompakte Ausbildung der Übergangsstelle zwischen den drei Wellenleitern, bei der jeder Wellenleiter von den anderen Wellenleitern entkoppelt ist. Außerdem ermöglicht die genannte Wahl der Wellenleitertypen eine besonders einfache Anordnung der Mischelemente.

Nach einer anderen Ausbildung der Erfindung ist der zweite Wellenleiter zum Überleiten hochfrequenter Signale mit einem ersten Rechteckhohlleiter derart verbunden, daß der zweite Wellenleiter in der Art eines Pfostens in der parallel zur kleineren Querschnittsabmessung verlaufenden Mittelebene des Hohlleiters in diesem geführt ist. Mit einer derartigen Anordnung ist eine einfache und effiziente, d. h. reflexionsarme Kopplung zwischen dem zweiten Wellenleiter und dem ersten Rechteckhohlleiter, insbesondere bezüglich dessen Grundwelle, erreicht, wobei der Rechteckhohlleiter ein dämpfungsarmes Zuführen und Ableiten der Wellen gestattet. Die genannte Anordnung verhindert darüber hinaus ein Ausbreiten der oben genannten, aus dem ersten Wellenleiter auf den zweiten Wellenleiter übergekoppelten Wellenform auf dem letzteren. Die genannte Wellenform ist in dem ersten Rechteckhohlleiter nicht ausbreitungsfähig. Die Ausbreitung der genannten Wellenform würde beispielsweise auch durch eine Überleitung vom zweiten Wellenleiter auf eine koaxiale Leitung unterbunden, wie sie aus dem Stand der Technik bekannt ist.

Nach einer vorteilhaften Weiterbildung der Erfindung ist der dritte Wellenleiter auf der den Mischelementen abgewandten Seite des Hohlleiters mit einem Sperrfilter versehen. Bei der vorstehend beschriebenen Anordnung verlaufen die Feldlinien der sich auf dem dritten Wellenleiter ausbreitenden Wellen senkrecht zu denen der Hohlleiterwellen, wodurch eine gute Entkopplung zwischen den Wellen auf dem dritten Wellenleiter und den Hohlleiterwellen erreicht wird. Da die Leiterteile des dritten Wellenleiters zugleich Teile des zweiten Wellenleiters bilden, auf den Wellen vom Hohlleiter übergekoppelt werden, ist an der den Mischelementen abgewandten Seite des Hohlleiters am zweiten bzw. dritten Wellenleiter ein Sperrfilter angeordnet, welches ein Überleiten der Energie der Rechteckhohlleiterwelle in eine andere Richtung als zu den Mischelementen hin verhindert.

In einer weiteren Ausgestaltung der Erfindung besteht das Sperrfilter aus einem Abschnitt einer koplanaren Leitungsanordnung, die aus leitenden Belägen des dielektrischen Trägers geformt ist. Ein derartiges Filter ist einfach und mit hoher Genauigkeit reproduzierbar herzustellen und weist eine hohe Sperrdämpfung auf.

Nach einer vorteilhaften Weiterbildung der Erfindung ist die Parallelplattenleitung durch Aufweiten eines ihrer Leiter in eine asymmetrische Streifenleitung übergeführt. Dadurch wird eine reflexions- und dämpfungsarme Transformation der symmetrischen Wellentypen der Parallelplattenleitung in asymmetrische Wellentypen der asymmetrischen Streifenleitung und umgekehrt erzielt.

Nach einer anderen Fortbildung der Erfindung ist die Parallelplattenleitung über die asymmetrische Streifenleitung mit einer koaxialen Leitung derart verbunden, daß der sich nicht aufweitende Leiter mit dem mittleren Leiter der koaxialen Leitung und der sich aufweitende Leiter mit dem äußeren Leiter der koaxialen Leitung verbunden ist. Ein derartiger Übergang auf eine bzw. von einer koaxialen Leitung ist einfach herstellbar und reflexionsarm. In Verbindung mit dem genannten Übergang zwischen der Parallelplattenleitung und der asymmetrischen Streifenleitung ergibt sich eine einfache und reflexionsarme Ein- bzw. Auskoppelvorrichtung von dem erfindungsgemäßen Mischer auf eine koaxiale Leitung und umgekehrt.

Nach einer weiteren Ausgestaltung der Erfindung ist das Gehäuse entlang der Ebene des dielektrischen Trägers aufgeteilt und der Träger durch Einklemmen zwischen den Teilen des Gehäuses gehaltert. Diese Ausbildung des Gehäuses gestattet eine einfache, exakte und mechanisch stabile Montage des dielektrischen Trägers im Gehäuse sowie eine einfache und zuverlässige elektrische Kontaktierung zwischen dem Gehäuse und wenigstens einem Teil der leitenden Beläge auf dem dielektrischen Träger.

Nach einer anderen Weiterbildung der Erfindung ist der erste Wellenleiter in einem durch Aufweiten der Schlitze zwischen den Teilen der Beläge gebildeten Übergang mit einem zweiten Rechteckhohlleiter verbunden und ist das Gehäuse wenigstens im Bereich dieses Übergangs als Rechteckhohlleiter ausgebildet. Dadurch wird ein einfacher und reflexionsarmer Übergang von der Schlitz- bzw. Flossenleitung auf einen Rechteckhohlleiter erhalten.

Nach einer anderen Ausgestaltung der Erfindung ist die Parallelplattenleitung in einem Übergang, der nach Art einer antipodalen Schlitz- bzw. Flossenleitung mit sich aufweitendem Zwischenraum zwischen den Belägen ausgeführt ist, mit einem dritten Rechteckhohlleiter verbunden und ist das Gehäuse wenigstens im Bereich dieses Übergangs als Rechteckhohlleiter ausgebildet. Durch einen derartigen Übergang, der einfach und genau herstellbar ist, wird die Welle auf der Parallelplattenleitung zunächst in eine Welle auf einer Schlitz- bzw. Flossenleitung und von dieser in eine Rechteckhohlleiterwelle umgewandelt. Dadurch wird eine dämpfungs- und reflexionsarme Kopplung zwischen der Parallelplattenleitung und dem Rechteckhohlleiter erzielt.

Nach einer weiteren Fortbildung der Erfindung sind Teile der leitenden Beläge, die auf beiden Seiten entlang von an das Gehäuse grenzenden Rändern des dielektrischen Trägers angeordnet sind, durch das Gehäuse elektrisch leitend miteinander verbunden. Dadurch ist eine induktivitätsarme Verbindung zwischen den genannten leitenden Belägen gewährleistet, die darüber hinaus einfach und zuverlässig ist.

Nach einer anderen Fortbildung der Erfindung sind wenigstens einige der Teile der leitenden Beläge, die auf beiden Seiten entlang von an das Gehäuse grenzenden Rändern des dielektrischen Trägers angeordnet sind, gegenüber dem Gehäuse elektrisch isoliert und mit gegen das Gehäuse und alle übrigen Teile der leitenden Beläge isolierten Zuführungen zum Anlegen von Gleichvorspannung an eines oder mehrere der Mischelemente versehen. Es ist damit möglich, die Arbeitspunkte der Mischelemente durch Wahl der Gleichvorspannungen zu verändern und damit die Eigenschaften des Mischers bezüglich der Erzeugung der Mischprodukte einzustellen. Für die hochfrequenten Signale stellt eine derartige Isolierung keine Beeinträchtigung dar, da bei einem hinreichend dünnen dielektrischen Träger und hinreichend großen Flächen der leitenden Beläge die Kapazität zwischen diesen Belägen zur Überkopplung der hochfrequenten Signale völlig ausreicht.

Nach einer anderen Weiterbildung der Erfindung sind zum Fernhalten der Gleichvorspannung von mit der Parallelplattenleitung verbundenen Wellenleitern die Leiter der Parallelplattenleitung unterbrochen und die Unterbrechungsstellen durch Koppelkapazitäten überbrückt. Die Gleichvorspannung der Mischelemente wird so wirkungsvoll von anderen, mit dem Mischer verbundenen Mikrowellenschaltungen ferngehalten, in denen sie kurzgeschlossen werden oder Schaden anrichten könnte. Ein Überleiten der hochfrequenten Signale ist durch die Koppelkapazitäten ohne Einschränkungen gewährleistet.

Nach einer vorteilhaften Ausgestaltung der Erfindung weisen die Mischelemente einen nichtlinearen Wirkwiderstand auf. Derartige Mischelemente werden insbesondere verwendet, wenn die Frequenz der Mischprodukte niedriger als die Frequenz des umzusetzenden Empfangssignals ist, d. h. bei Abwärtsmischern.

Nach einer anderen Ausgestaltung der Erfindung weisen die Mischelemente einen nichtlinearen Blindwiderstand auf. Derartige Mischelemente werden bevorzugt verwendet, wenn die Frequenz der Mischprodukte höher liegt als die Frequenz des umzusetzenden Empfangssignals, d. h. bei Aufwärtsmischern.

Nach einer vorteilhaften Weiterbildung der Erfindung sind die Mischelemente als Dioden ausgebildet. Dioden sind einfach aufgebaut, weisen eine hohe Nichtlinearität auf und bei unterschiedlicher Ausgestaltung und Polung der Gleichvorspannung wahlweise einen nichtlinearen Wirkwiderstand oder Blindwiderstand. Sie gestatten einen hohen Wirkungsgrad bei der Umsetzung der hochfrequenten Signale.

Nach einer Fortbildung der Erfindung wird den Mischelementen ein in seiner Frequenz umzusetzendes Empfangssignal über den ersten Wellenleiter und ein Pumpsignal über den zweiten Wellenleiter zugeführt und wird über den dritten Wellenleiter ein in den Mischelementen gebildetes Zwischenfrequenzsignal von den Mischelementen abgeleitet. Insbesondere bei einem Abwärtsmischer ergibt sich dadurch eine besonders vorteilhafte Anpassung der Wellenleiter an die Frequenzen der übertragenen Wellen. Es ist jedoch auch möglich, die Einspeisung bzw. Ableitung der genannten Signale in anderer Zuordnung zu den Wellenleitern vorzunehmen.

Nach einer anderen Ausgestaltung der Erfindung sind die Mischelemente und ggf. die Koppelkapazitäten «beam-lead»-Bauelemente. Derartige Bauelemente weisen geringe parasitäre Kapazitäten und Induktivitäten auf und sind daher bevorzugt für hohe Frequenzen und breitbandige Schaltungen verwendbar.

Nach einer weiteren Ausgestaltung der Erfindung verbinden zwei Mischelemente den mittleren Belag auf der Oberseite des Trägers mit jeweils einem der Teile der Beläge des ersten Wellenleiters auf der Oberseite und zwei weitere Mischelemente den mittleren Belag auf der Unterseite des Trägers mit jeweils einem der Teile der Beläge des ersten Wellenleiters auf der Unterseite unmittelbar an der Übergangsstelle der Wellenleiter. Bei dieser Ausgestaltung wird eine sehr kompakte Anordnung der Mischelemente erhalten.

Die Erfindung wird nachstehend anhand einiger in der Zeichnung dargestellter Ausführungsbeispiele näher erläutert. Es zeigen

Fig. 1 eine Ausführungsform eines dielektrischen Trägers mit einer Übergangsstelle dreier Wellenleiter gemäß der Erfindung,

Fig. 2 eine andere Ausführungsform einer Übergangsstelle der Wellenleiter nach der Erfindung,

Fig. 3 ein weiteres Ausführungsbeispiel des erfindungsgemäßen Mischers in einem Längsschnitt in der Ebene des dielektrischen Trägers,

Fig. 4 einen Längsschnitt durch die Anordnung nach Fig. 3 senkrecht zur Ebene des dielektrischen Trägers,

Fig. 5 einen Querschnitt senkrecht zur Längsmittelachse der Wellenleiter eines Ausführungsbeispiels des erfindungsgemäßen Mischers am Ort der Mischelemente,

Fig. 6 ein weiteres Ausführungsbeispiel eines erfindungsgemäßen Mischers in einer Darstellung gemäß Fig. 5,

Fig. 7 ein weiteres Ausführungsbeispiel der Erfindung in der Draufsicht auf den die Übergangsstelle zwischen den Wellenleitern umfassenden Teil des dielektrischen Trägers.

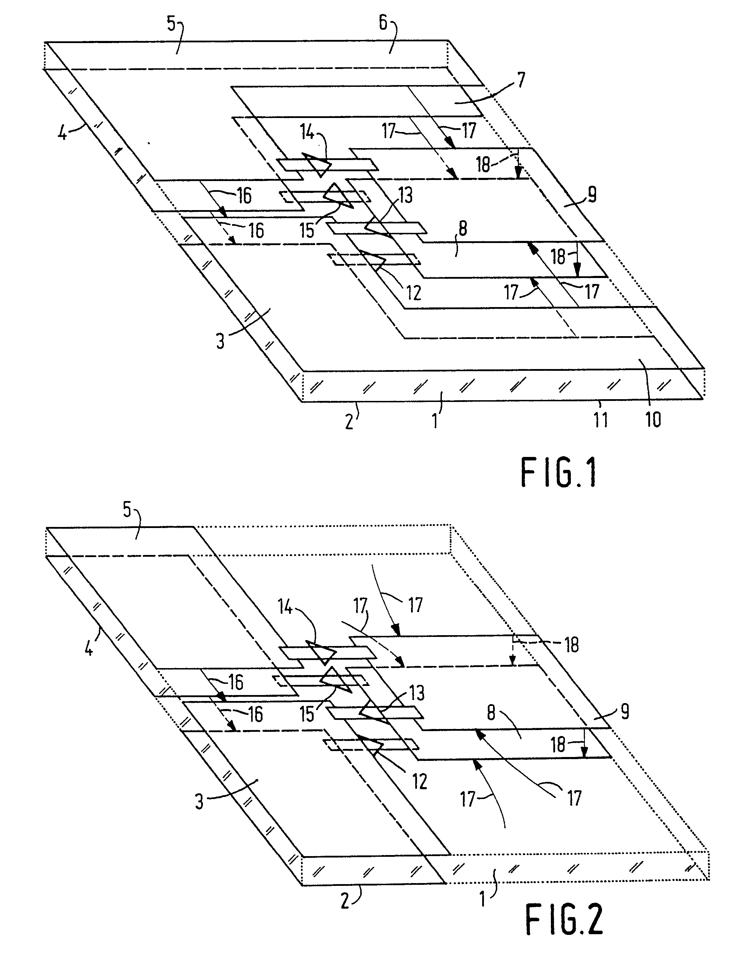

Fig. 1 zeigt einen Ausschnitt aus einem beidseitig mit Teilen 2 bis 11 leitender Beläge versehenen, plattenförmigen dielektrischen Träger 1. Ein erster Wellenleiter wird gebildet durch zwei auf der Oberseite des Trägers 1 angeordnete, durch einen Schlitz voneinander getrennte Teile 3, 5 der Beläge sowie zu diesen deckungsgleich auf der Unterseite des Trägers 1 angeordnete Teile 2, 4 der Beläge. Das elektrische Feld einer sich auf dem ersten Wellenleiter ausbreitenden elektromagnetischen Welle verläuft im wesentlichen in den Schlitzen zwischen den Teilen 3, 5 der Beläge an der Oberseite und 2, 4 an der Unterseite und ist durch Pfeile 16 angedeutet. Der erste Wellenleiter hat somit die Gestalt einer auf beiden Seiten des Trägers 1 ausgeführten Schlitz- bzw. Flossenleitung.

In axialer Richtung ist an diesen ersten Wellenleiter an einer Übergangsstelle ein zweiter Wellenleiter angeschlossen, der aus an der Ober- und Unterseite des Trägers 1 jeweils deckungsgleich übereinander angeordneten mittleren Belägen 8, 9 und äußeren Teilen 6, 7, 10, 11 der Beläge besteht. Der zweite Wellenleiter hat die Gestalt eines beidseitig des Trägers 1 ausgeführten koplanaren Wellenleiters, dessen Mittelachse mit der des ersten Wellenleiters zusammenfällt. Die äußeren Teile 6, 10 der Beläge auf der Oberseite sind mit den an sie grenzenden Teilen 3, 5 der Beläge des ersten Wellenleiters einstückig ausgeführt; entsprechendes gilt für die Teile der Beläge auf der Unterseite. Das elektrische Feld der sich auf den zweiten Wellenleiter ausbreitenden elektromagnetischen Welle ist jeweils von einem der äußeren Teile 6, 7, 10, 11 der Beläge zu dem auf der gleichen Seite des Trägers 1 angeordneten mittleren Belag 8, 9 gerichtet und durch Pfeile 17 angedeutet.

Ein dritter Wellenleiter wird durch die mittleren Beläge 8, 9 des zweiten Wellenleiters gebildet und hat die Form einer Parallelplattenleitung. Die mittleren Beläge 8, 9 sind von den übrigen Belägen galvanisch getrennt. Der dritte Wellenleiter führt eine Welle, deren elektrisches Feld im wesentlichen senkrecht zur flächigen Ausdehnung der Beläge 8, 9 gerichtet und durch die Pfeile 18 angedeutet ist.

An der Übergangsstelle der drei Wellenleiter 2 bis 5, 6 bis 11, 8 und 9 sind vier Mischelemente 12 bis 15 angeordnet, die in dem vorliegenden Ausführungsbeispiel durch Halbleiterdioden gebildet werden. Eine mögliche Polung der Dioden ist in der schematischen Darstellung der Fig. 1 durch die Pfeile angedeutet. Zwei Dioden 13, 14 befinden sich oberhalb des dielektrischen Trägers 1, zwei weitere 12, 15 auf der Unterseite. Je eine der Dioden 12 bis 15 verbindet einen der mittleren Beläge 8, 9 mit einem der Teile 2 bis 5 der Beläge des ersten Wellenleiters. Die Dioden 12 bis 15 können wahlweise derart angeordnet werden, daß sie jeweils einen der mittleren Beläge 8, 9 mit jeweils einem der äußeren Teile 6, 7, 10, 11 der Beläge des zweiten Wellenleiters verbinden.

Die leitenden Beläge 2 bis 11 der drei Wellenleiter sind beispielsweise aus einer beidseitigen, geschlossenen Metallisierung des dielektrischen Trägers 1 durch einen photolithographischen Prozeß herausgearbeitet. Die Dioden sind als «beam-lead»-Bauelemente ausgebildet und unmittelbar auf die leitenden Beläge 2 bis 5, 8, 9 gelötet.

Über den ersten Wellenleiter wird den Mischelementen ein in seiner Frequenz umzusetzendes Empfangssignal zugeführt, während den Mischelementen über den zweiten Wellenleiter ein Pumpsignal zugeleitet wird. Ein als Mischprodukt dieser Signale in den Mischelementen gebildetes Zwischenfrequenzsignal wird über den dritten Wellenleiter von dem Mischelementen abgeleitet.

Bei der Anordnung nach Fig. 1 ist eine Überkopplung der Wellen vom zweiten oder dritten Wellenleiter auf einen anderen nur über die Dioden 12 bis 15 möglich. Von der auf den ersten Wellenleiter einfallenden Welle werden gleiche Teile auf die Schlitze übergekoppelt, die durch die Teile der Beläge 6, 7 und 8, 9 einerseits sowie 8, 9 und 10, 11 andererseits gebildet werden. Die Wellenform, die sich dadurch auf dem zweiten Wellenleiter ausbreitet, weist ein elektrisches Feld auf, das zwischen den Belägen 6, 7 und 8, 9 im wesentlichen die Richtung der eingezeichneten Pfeile 17 hat und das zwischen den Belägen 8, 9 und 10, 11 im wesentlichen die entgegengesetzte Richtung der dort eingezeichneten Pfeile 17 einnimmt. Die Dioden 12 bis 15 können dicht nebeneinander eingebaut werden, so daß die unterschiedlichen, von den einzelnen Wellen erzeugten hochfrequenten Ströme keine oder nur sehr geringe Umwege durchfließen. Dadurch weist die vorliegende Anordnung im Betrieb eine hohe Bandbreite auf.

Die dem Zwischenfrequenzsignal zugeordneten Ströme, die im dritten Wellenleiter 8, 9 fließen, werden über die Kapazitäten zwischen den leitenden Belägen 2 und 3 bzw. 4 und 5 geführt. Da der dielektrische Träger sehr dünn ist, beispielsweise 0,254 mm, und die Beläge 2 bis 5 hinreichend großflächig sind, betragen die genannten Kapazitäten mehrere 10 pF, so daß die hochfrequenten Ströme ungehindert fließen können. Bei sehr niederfrequenten Mischprodukten kann der Stromweg über ein in Fig. 1 nicht dargestelltes Gehäuse geführt werden, in dem der dielektrische Träger gehalten ist und das die leitenden Beläge 2 und 3 bzw. 4 und 5 galvanisch miteinander verbindet.

Durch Wahl der Breiten der Schlitze zwischen den Belägen und der Breite der Leiterteile 8 und 9 des dritten Wellenleiters lassen sich die Wellenwiderstände der drei Wellenleiter unabhängig voneinander derart einstellen, daß die Wellenleiter an der Übergangsstelle reflexionsarm abgeschlossen sind. Zum Verbessern der Anpassung können in den einzelnen leitenden Belägen 2 bis 11 zusätzlich verschiedenartige Aussparungen vorgesehen werden, mit denen insbesondere Kapazitäten, Induktivitäten und Resonanzkreise in bekannter Art ohne zusätzlichen Fertigungsaufwand nachgebildet werden können.

Fig. 2 zeigt eine Abwandlung der in Fig. 1 dargestellten Ausführungsform der Erfindung. Einzelteile dieser Anordnung, die der der Fig. 1 entsprechen, sind mit gleichen Bezugszeichen versehen. Die Leiteranordnung nach Fig. 2 wird wieder von einem nicht dargestellten, elektrisch leitenden Gehäuse umschlossen. Sie unterscheidet sich von der in Fig. 1 dargestellten Anordnung im wesentlichen dadurch, daß die äußeren Leiterteile des zweiten Wellenleiters unmittelbar durch die Wand des Gehäuses gebildet werden, daß also die Teile 6, 7, 10, 11 der Beläge fehlen. Mit den Pfeilen 17 ist das elektrische Feld der Wellen auf dem zweiten Wellenleiter zwischen dem Gehäuse und den leitenden Belägen 8, 9 angedeutet.

Den Anordnungen nach Fig. 1 und 2 ist gemeinsam, daß die leitenden Beläge auf der Ober- und Unterseite des dielektrischen Trägers identische Abmessungen aufweisen und deckend übereinanderliegen. Durch einen derartigen symmetrischen Aufbau wird erreicht, daß der beschriebene Mischer auch bei sehr hohen Frequenzen eingesetzt werden kann.

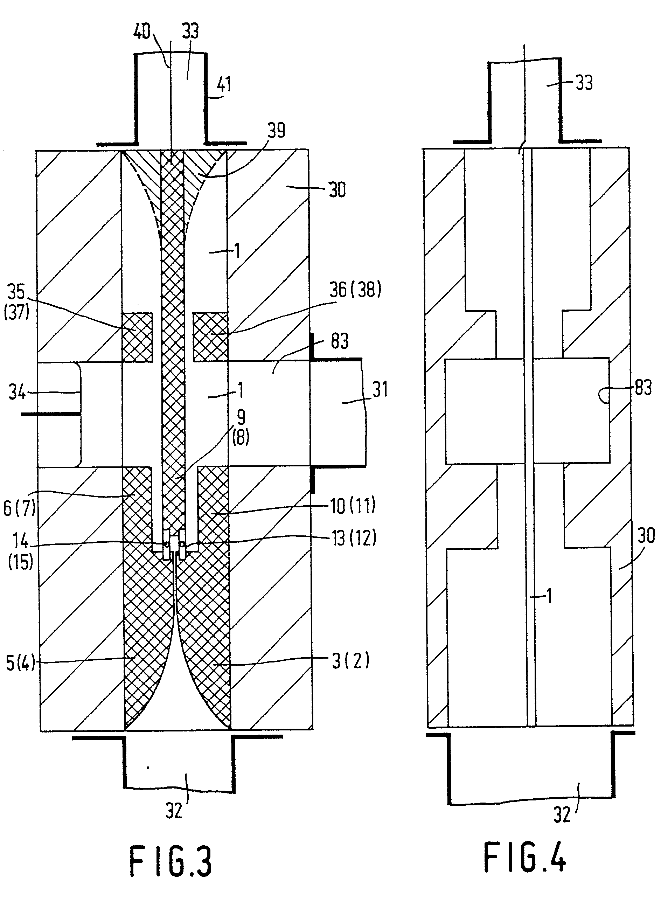

Fig. 3 zeigt eine schematische Darstellung eines Längsschnitts durch das Gehäuse 30 eines Ausführungsbeispiels für einen erfindungsgemäßen Mischer mit einer Draufsicht auf den in das Gehäuse 30 eingesetzten dielektrischen Träger 1. Die in der Draufsicht erkennbaren Teile 3, 5, 6, 9, 10 der Beläge sind kreuzweise schraffiert dargestellt, deckungsgleich dazu an der Unterseite des dielektrischen Trägers 1 befinden sich die Teile 2, 4, 7, 8, 11 der Beläge. Weiterhin sind die Mischerdioden 13, 14 in der Draufsicht zu erkennen, deckungsgleich dazu an der Unterseite des dielektrischen Trägers befinden sich die Mischerdioden 12, 15. Die leitenden Beläge weisen die in der Fig. 1 dargestellte Form auf.

Das Gehäuse hat die Form zweier gekreuzter Hohlleiterstrukturen aus Abschnitten mit vorzugsweise rechteckförmigen Querschnitten, wobei der dielektrische Träger in den den schmalen Querschnittsabmessungen der Rechteckhohlleiterabschnitte parallelen Längsmittelebenen angeordnet ist. Das Gehäuse 30 ist mit einem ersten Rechteckhohlleiter 31 und einem zweiten Rechteckhohlleiter 32 sowie einer koaxialen Leitung 33 verbunden.

Über den zweiten Rechteckhohlleiter 32 wird das umzusetzende Empfangssignal auf den ersten Wellenleiter übergekoppelt und damit den Mischelementen zugeführt. Zum Erzielen eines reflexionsarmen Übergangs zwischen dem zweiten Rechteckhohlleiter und dem ersten Wellenleiter sind die leitenden Beläge 2 bis 5 an ihren dem zweiten Rechteckhohlleiter zugewandten Enden in einem allmählichen Übergang verschmälert derart, daß sich die Schlitze zwischen den Belägen trichterförmig symmetrisch aufweiten bis auf die volle Höhe des zweiten Rechteckhohlleiters 32. Das Gehäuse 30 ist im Bereich zwischen dem zweiten Rechteckhohlleiter 32 und der Übergangsstelle der Wellenleiter als Rechteckhohlleiter mit den Maßen des zweiten Rechteckhohlleiters 32 ausgeführt.

Über den ersten Rechteckhohlleiter 31 wird dem Mischer ein Pumpsignal zugeführt. Dieses wird aus dem Rechteckhohlleiter 31 in einen bezüglich seiner Querschnittsabmessungen mit denen des ersten Rechteckhohlleiters 31 identischen, innerhalb des Gehäuses 30 geführten Hohlleiterabschnitt 83 übergekoppelt. Der Hohlleiterabschnitt 83 ist an seinem dem ersten Rechteckhohlleiter 31 abgewandten Ende mit einem Kurzschlußschieber 34 abgeschlossen. Der dielektrische Träger 1 ist derart durch die parallel zur schmalen Abmessung verlaufende Mittelebene des Hohlleiterabschnitts 83 geführt, daß die leitenden Beläge 8, 9 des zweiten bzw. dritten Wellenleiters eine Art Koppelpfosten zur Überkopplung elektromagnetischer Wellen aus dem Hohlleiterabschnitt 83 in den zweiten Wellenleiter 6 bis 11 bilden. Durch Wahl der Abmessungen des zweiten Wellenleiters, d. h. seiner Länge und seines Wellenwiderstandes, sowie Abstimmung des Kurzschlusses mit dem Kurzschlußschieber 34 wird eine reflexionsarme Überkopplung des Pumpsignals vom ersten Rechteckhohlleiter 31 in den zweiten Wellenleiter erzielt.

Die durch Überkopplung vom ersten Wellenleiter auf den zweiten Wellenleiter entstehende Wellenform wird durch den beschriebenen Koppelpfosten nicht auf den ersten Rechteckhohlleiter 31 übergekoppelt und breitet sich auch nicht weiter auf dem dritten Wellenleiter aus. Dadurch sind der erste und der zweite Rechteckhohlleiter 31, 32 und die koaxiale Leitung 33 voneinander entkoppelt.

Auf der dem zweiten Wellenleiter abgewandten Seite des Hohlleiterabschnitts 83 ist ein Sperrfilter angeordnet, durch das ein Übertragen des Pumpsignals in Richtung auf die koaxiale Leitung verhindert wird. Dieses Sperrfilter besteht beispielsweise aus je zwei leitenden Belägen 35, 36 auf der Oberseite und dazu deckungsgleich angeordneten leitenden Belägen 37 und 38 auf der Unterseite des dielektrischen Trägers 1. Die leitenden Beläge 35 bis 38 bilden mit den Belägen 8, 9 beispielsweise eine koplanare Leitung ähnlich dem zweiten Wellenleiter, deren Länge in Ausbreitungsrichtung einem Viertel der Wellenlänge des Pumpsignals entspricht und die am Ende leerläuft. Dadurch wird für das Pumpsignal im Bereich der seitlichen Wand des Hohlleiterabschnitts 83 ein scheinbarer Kurzschluß erzeugt. Ohne zusätzlichen Fertigungsaufwand sind jedoch auch Sperrfilter mit mehreren Kreisen, d. h. mit in mehrere Abschnitte unterschiedlicher Breite gegliederten leitenden Belägen 35 bis 38 herstellbar. Auch kann ein Sperrfilter an dieser Stelle dadurch erzielt werden, daß das Gehäuse 30 Vorsprünge aufweist, deren Querschnitte die Form der leitenden Beläge 35 bis 38 annehmen.

Wird die Übergangsstelle zwischen den drei Wellenleitern im Mischer nach Fig. 3 in der in Fig. 2 dargestellten Weise ausgeführt, ist es auch möglich, die Mischelemente 12 bis 15 näher an den Hohlleiterabschnitt 83 zu rücken derart, daß der zweite Wellenleiter kürzer wird. Im Grenzfall liegen die Mischelemente 12 bis 15 unmittelbar im Bereich der Wand des Hohlleiterabschnitts 83. Dadurch wird eine besonders kompakte Bauweise für den erfindungsgemäßen Mischer erzielt. Die Ausbildung des zweiten Wellenleiters als koplanare Leitung nach Fig. 1 und 3 bietet demgegenüber eine zusätzliche Möglichkeit der Wellenwiderstandsanpassung.

Hinter dem Sperrfilter 35 bis 38 wird der dritte Wellenleiter durch allmähliches Aufweiten des Endabschnitts 39 des leitenden Belages 9 an der Unterseite des dielektrischen Trägers 1 in eine asymmetrische Streifenleitung überführt. An diese asymmetrische Streifenleitung ist die koaxiale Leitung 33 derart angeschlossen, daß ihr Innenleiter 40 mit dem leitenden Belag 8 an der Oberseite des dielektrischen Trägers 1 und ihr Außenleiter 41 mit dem Endabschnitt 39 verbunden ist. Ein derart ausgebildeter Übergang vom dritten Wellenleiter zur koaxialen Leitung ist besonders breitbandig.

Wird anstelle der koaxialen Leitung 33 zum Ableiten des Zwischenfrequenzsignals ein Hohlleiter verwendet, was für hohe Zwischenfrequenzen vorteilhaft ist, wird an den dritten Wellenleiter anstelle des dargestellten Übergangs ein Abschnitt einer antipodalen Flossenleitung mit sich zum Hohlleiter hin allmählich aufweitendem Schlitz zwischen den leitenden Belägen angefügt. Derartige Übergänge sind aus der Literatur bekannt.

Fig. 4 zeigt einen Längsschnitt durch den Mischer nach Fig. 3 senkrecht zur Ebene des dielektrischen Trägers. Diese Figur zeigt deutlich die Gliederung des Gehäuses 30 in mehrere Rechteckhohlleiterabschnitte mit im wesentlichen gleichen Höhen und unterschiedlichen Breiten.

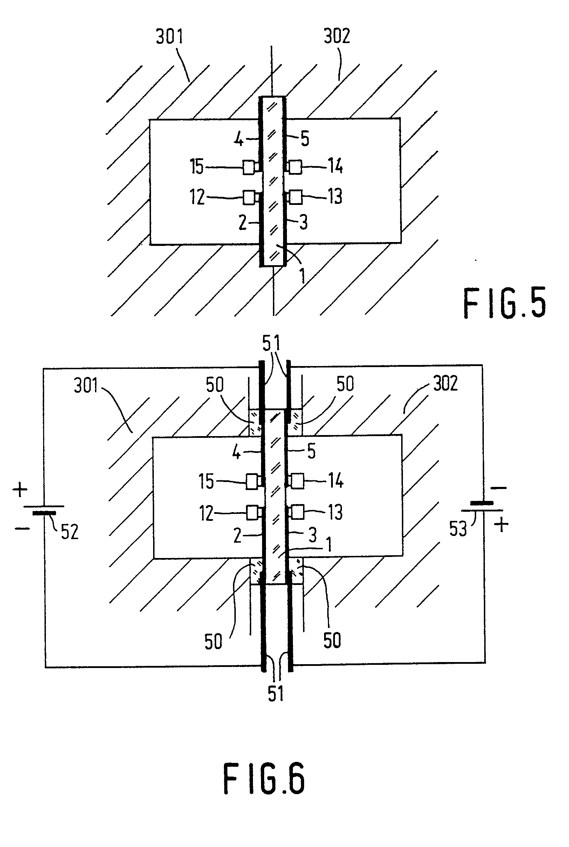

Fig. 5 zeigt einen Querschnitt durch einen Mischer nach Fig. 3 nahe den Mischelementen. Das Gehäuse 30 besteht aus zwei Hälften 301 und 302, zwischen denen der dielektrische Träger 1 durch Einklemmen gehalten ist. Dabei werden die leitenden Beläge 2, 4 mit der einen Gehäusehälfte 301 und die leitenden Beläge 3, 5 mit der anderen Gehäusehälfte 302 galvanisch verbunden. Über den metallischen Kontakt zwischen den Gehäusehälften 301, 302 sind dann die leitenden Beläge auf beiden Seiten des dielektrischen Trägers 1 an ihren Rändern galvanisch verbunden.

Im Bereich des ersten Wellenleiters werden die Querschnittsabmessungen des Gehäuses vorzugsweise denen des zweiten Hohlleiters 32 angepaßt, der in der Regel genormte Maße aufweist, um Reflexionen gering zu halten. Für die Führung der Welle auf dem ersten Wellenleiter sind die Gehäuseabmessungen von untergeordneter Bedeutung, da die Welle überwiegend in den Schlitzen zwischen den leitenden Belägen 3 und 5 bzw. 2 und 4 geführt wird. Im Bereich des dritten Wellenleiters wird das Gehäuse in bekannter Weise ähnlich dem für eine Streifenleitungsschaltung dimensioniert.

Fig. 6 zeigt einen Querschnitt durch einen Mischer nach einer anderen Ausführungsform der Erfindung, bei dem im Gegensatz zu Fig. 5 die Gehäusehälften 301, 302 galvanisch gegeneinander isoliert sind. Zwischen den Gehäusehälften 301, 302 und dem dielektrischen Träger 1 sind Isolierstücke 50 eingefügt, durch die auch die leitenden Beläge 2 bis 5 galvanisch von den Gehäusehälften 301, 302 getrennt sind. Zwischen den Isolierstücken 50 und den leitenden Belägen 2 bis 5 sind ferner Kontakte 51 durch Einklemmen gehaltert, die mit Gleichspannungsquellen 52, 53 verbunden sind. Auf diese Weise können den Mischelementen 12 bis 15 unterschiedliche Gleichvorspannungen zugeführt werden, wobei die Isolierstücke 50 ein Kurzschließen der Spannungsquellen 52, 53 über die Gehäusehälften 301, 302 verhindern. Die Spannungsquellen 52, 53 dienen zum Verschieben der Arbeitspunkte auf den nichtlinearen Strom-Spannungs-Kennlinien der Mischelemente 12 bis 15. Dadurch kann insbesondere bei Pumpsignalen geringer Leistung eine Verbesserung der Arbeitsweise des Mischers erzielt werden. Die Isolierstücke 50 üben keinen Einfluß auf hochfrequente Signale aus, lediglich sehr niederfrequente Zwischenfrequenzsignale können in ihrer Ausbreitung behindert sein.

Die Fig. 5 und 6 zeigen darüber hinaus deutlich die beidseitige Anbringung der Mischelemente 12 bis 15 auf dem dielektrischen Träger 1.

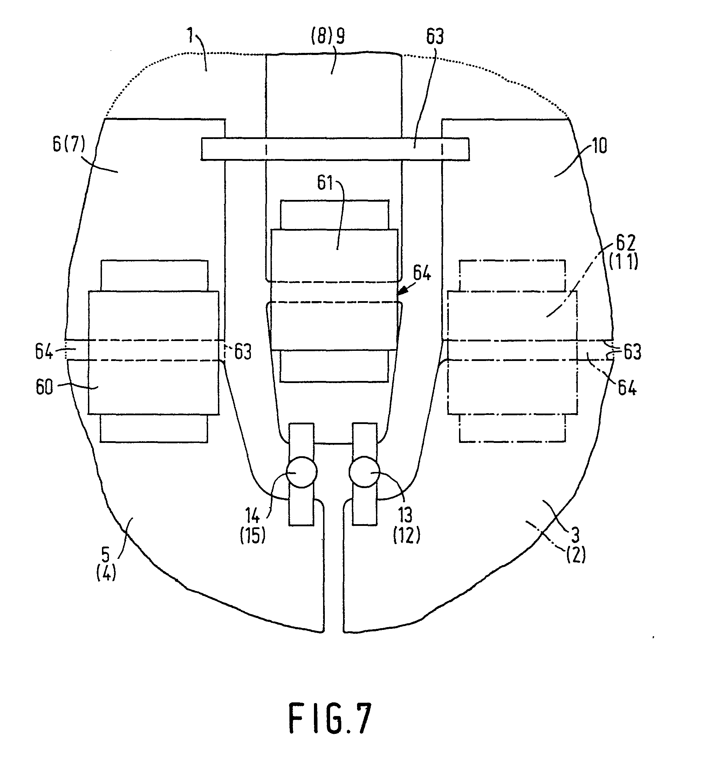

Fig. 7 zeigt für ein weiteres Ausführungsbeispiel der Erfindung einen Ausschnitt aus einer Draufsicht auf den dielektrischen Träger 1. Auf der Oberseite des dielektrischen Trägers sind die leitenden Beläge 3, 5, 6, 9 und 10 angeordnet, deckungsgleich dazu auf der Unterseite des dielektrischen Trägers 1 befinden sich die leitenden Beläge 2, 4, 7, 8 und 11. Die strichpunktierten Linien 63 zeigen an, wo die Konturen der leitenden Beläge auf der Unterseite von denen der Oberseite abweichen. An den mit 64 gekennzeichneten Stellen sind die leitenden Beläge unterbrochen, um den Mischelementen 12 bis 15 getrennte Gleichvorspannungen zuzuführen. Diese Trennstellen sind durch Kondensatoren 60, 61 auf der Oberseite und 62 auf der Unterseite des dielektrischen Trägers 1 hochfrequenzmäßig überbrückt. Die Kondensatoren sind als «beam-lead»-Bauelemente ausgestaltet und wie die Mischelemente 12 bis 15 durch Löten mit den leitenden Belägen verbunden.

Die Konturen der leitenden Beläge 2 bis 5 sind im Bereich der Mischelemente 12 bis 15 abgerundet. Diese Maßnahme trägt zur Verminderung von Stromleitungsverlusten bei.

Bei der Anordnung nach Fig. 7 ist zusätzlich eine leitende Brücke 63, beispielsweise aus Golddraht, eingefügt, die die leitenden Beläge 6 und 10 miteinander verbindet, gegenüber dem leitenden Belag 9 jedoch isoliert ist. Mit einer derartigen Brücke wird die vom ersten Wellenleiter auf dem zweiten Wellenleiter angeregte Wellenform kurzgeschlossen und dadurch zusätzlich bedämpft. Außerdem kann eine zusätzliche Verbesserung der Anpassung zwischen den Wellenleitern und den Mischelementen 12 bis 15 erzielt werden.

## Patentansprüche

1. Mischer, insbesondere zum Betrieb im Mikrowellen- und Millimeterwellenbereich, mit vier im wesentlichen einen Ring bildenden, zweipoligen Mischelementen (12 bis 15), die im Bereich einer Übergangsstelle wenigstens zweier Wellenleiter (2 bis 5, 6 bis 11) angeordnet sind, von denen ein erster (2 bis 5) eine schlitzförmige und ein zweiter (6 bis 11) eine aus wenigstens einem mittleren (9) und darum herum angeordneten äußeren Leiterteilen (6, 10) bestehende Leiterstruktur umfaßt, von der zumindest die Leiterteile des ersten Wellenleiters (3, 5) und das mittlere Leiterteil (9) des zweiten Wellenleiters (6 bis 11) als Beläge auf der Oberseite eines plattenförmigen Trägers (1) aus dielektrischem Material angeordnet sind, dadurch gekennzeichnet, daß

– der Träger (1) auf seiner Unterseite mit leitenden Belägen (2, 4, 7, 8, 11) versehen ist, die wenigstens nahezu übereinstimmend mit den Belägen auf der Oberseite geformt und zumindest im wesentlichen deckungsgleich dazu angeordnet sind,

– jeder der beiden Wellenleiter die zu den Belägen (3, 5, 6, 9, 10) auf der Oberseite deckungsgleich angeordneten Beläge (2, 4, 7, 8,11) auf der Unterseite des Trägers (1) mit umfaßt,

– ein dritter Wellenleiter aus den Belägen (8, 9) auf der Ober- und Unterseite gebildet wird, die die mittleren Leiterteile des zweiten Wellenleiters bilden, und

– jeweils zwei der Mischelemente (12 bis 15) auf jeder Seite des Trägers (1) je einen der mittleren Beläge (8, 9) mit je einem der Teile der übrigen Beläge (2 bis 7, 10, 11) verbindend angeordnet sind.

2. Mischer nach Anspruch 1, dadurch gekennzeichnet, daß die die Leiterteile des ersten Wellenleiters bildenden Teile (2 bis 5) der Beläge und die auf der jeweils gleichen Seite des dielektrischen Trägers (1) benachbart angeordneten äußeren Teile (6, 7, 10, 11) der Beläge des zweiten Wellenleiters einstückig ausgebildet sind.

3. Mischer nach Anspruch 1, dadurch gekennzeichnet, daß der Träger (1) aus dielektrischem Material in einem elektrisch leitenden Gehäuse (30) angeordnet ist.

4. Mischer nach Anspruch 1, dadurch gekennzeichnet, daß der erste Wellenleiter als Schlitzbzw. Flossenleitung und der zweite Wellenleiter als koplanare Leitung ausgebildet ist.

5. Mischer nach Anspruch 1, dadurch gekennzeichnet, daß der zweite Wellenleiter zum Überleiten hochfrequenter Signale mit einem ersten Rechteckhohlleiter (31, 83) verbunden ist derart, daß der zweite Wellenleiter in der Art eines Pfostens in der parallel zur kleineren Querschnittsabmessung verlaufenden Mittelebene des Hohlleiters (31, 83) in diesem geführt ist.

6. Mischer nach Anspruch 5, dadurch gekennzeichnet, daß der dritte Wellenleiter auf der den Mischelementen abgewandten Seite des Hohlleiters (31, 38) mit einem Sperrfilter (35 bis 83) versehen ist.

7. Mischer nach Anspruch 6, dadurch gekennzeichnet, daß das Sperrfilter (35 bis 38) aus einem Abschnitt einer koplanaren Leitungsanordnung besteht, die aus leitenden Belägen des dielektrischen Trägers (1) geformt ist.

8. Mischer nach Anspruch 4, dadurch gekennzeichnet, daß die Parallelplattenleitung durch Aufweiten eines ihrer Leiter (39) in eine asymmetrische Streifenleitung übergeführt ist.

9. Mischer nach Anspruch 8, dadurch gekennzeichnet, daß die Parallelplattenleitung über die asymmetrische Streifenleitung mit einer koaxialen Leitung (33) verbunden ist derart, daß der sich nicht aufweitende Leiter mit dem mittleren Leiter (40) der koaxialen Leitung (33) und der sich aufweitende Leiter mit dem äußeren Leiter (41) der koaxialen Leitung (33) verbunden ist.

10. Mischer nach Anspruch 3, dadurch gekennzeichnet, daß das Gehäuse (30) entlang der Ebene des dielektrischen Trägers (1) aufgeteilt und der Träger (1) durch Einklemmen zwischen den Teilen (301, 302) des Gehäuses (30) gehaltert ist.

11. Mischer nach Anspruch 3 und 4, dadurch gekennzeichnet, daß der erste Wellenleiter in einem durch Aufweiten der Schlitze zwischen den Teilen (2 bis 5) der Beläge gebildeten Übergang mit einem zweiten Rechteckhohlleiter (32) verbunden ist und daß das Gehäuse (30) wenigstens im Bereich dieses Übergangs als Rechteckhohlleiter ausgebildet ist.

12. Mischer nach Anspruch 3 und 4, dadurch gekennzeichnet, daß die Parallelplattenleitung (8, 9) in einem Übergang, der nach Art einer antipodalen Schlitz- bzw. Flossenleitung mit sich aufweitendem Zwischenraum zwischen den Belägen (8, 9) ausgeführt ist, mit einem dritten Rechteckhohlleiter verbunden ist und daß das Gehäuse (30) wenigstens im Bereich dieses Übergangs als Rechteckhohlleiter ausgebildet ist.

13. Mischer nach Anspruch 3, dadurch gekennzeichnet, daß Teile (2, 3; 4, 5; 6, 7; 10, 11) der leitenden Beläge, die auf beiden Seiten entlang von an das Gehäuse (30) grenzenden Rändern des dielektrischen Trägers (1) angeordnet sind, durch das Gehäuse (30) elektrisch leitend miteinander verbunden sind.

14. Mischer nach Anspruch 3, dadurch gekennzeichnet, daß wenigstens einige der Teile (2, 3; 4, 5; 6, 7; 10, 11) der leitenden Beläge, die auf beiden Seiten entlang von an das Gehäuse (30) grenzenden Rändern des dielektrischen Trägers (1) angeordnet sind, gegenüber dem Gehäuse (30) elektrisch isoliert und mit gegen das Gehäuse (30) und alle übrigen Teile der leitenden Beläge isolierten Zuführungen (51) zum Anlegen von Gleichvorspannung an eines oder mehrere der Mischelemente (12 bis 15) versehen sind.

15. Mischer nach Anspruch 4 und 14, dadurch gekennzeichnet, daß zum Fernhalten der Gleichvorspannung von mit der Parallelplattenleitung (8, 9) verbundenen Wellenleitern die Leiter der Parallelplattenleitung unterbrochen (64) und die Unterbrechungsstellen durch Koppelkapazitäten (61) überbrückt sind.

16. Mischer nach Anspruch 1, dadurch gekennzeichnet, daß die Mischelemente (12 bis 15) einen nichtlinearen Wirkwiderstand aufweisen.

17. Mischer nach Anspruch 1, dadurch gekennzeichnet, daß die Mischelemente (12 bis 15) einen nichtlinearen Blindwiderstand aufweisen.

18. Mischer nach Anspruch 1, dadurch gekennzeichnet, daß die Mischelemente (12 bis 15) als Dioden ausgebildet sind.

19. Mischer nach Anspruch 1, dadurch gekennzeichnet, daß den Mischelementen (12 bis 15) ein in seiner Frequenz umzusetzendes Empfangssignal über den ersten Wellenleiter und ein Pumpsignal über den zweiten Wellenleiter zugeführt und daß über den dritten Wellenleiter ein in den Mischelementen (12 bis 15) gebildetes Zwischenfrequenzsignal von den Mischelementen (12 bis 15) abgeleitet wird.

20. Mischer nach einem oder mehreren der vorhergehenden Ansprüche, dadurch gekennzeichnet, daß die Mischelemente (12 bis 15) und ggf. die Koppelkapazitäten (61 bis 63) «beam-lead»-Bauelemente sind.

21. Mischer nach Anspruch 19, dadurch gekennzeichnet, daß zwei Mischelemente (13, 14) den mittleren Belag (9) auf der Oberseite des Trägers (1) mit jeweils einem der Teile (3, 5) der Beläge des ersten Wellenleiters auf der Oberseite und zwei weitere Mischelemente (12, 15) den mittleren Belag (8) auf der Unterseite des Trägers (1) mit jeweils einem der Teile (2, 4) der Beläge des ersten Wellenleiters auf der Unterseite unmittelbar an der Übergangsstelle der Wellenleiter verbinden.

## Claims

1. A mixer, particularly for use in the microwave and millimetre wave ranges, comprising four bipolar mixing elements (12 to 15) which in essence form a ring and are arranged in the region of a junction between at least two waveguides (2 to 5, 6 to 11), of which a first waveguide (2 to 5) comprises a slotted line structure and a second waveguide (6 to 11) comprises a line structure formed by at least a central line portion (9) and outer line portions (6, 10) arranged around this central portion of which at least the line portions of the first waveguide (3, 5) and the central line portion (9) of the second waveguide (6 to 11) are provided as layers on the upper surface of a laminar substrate (1) made of a dielectric material, characterized in that

— the substrate (1) is provided on its bottom side with conductive layers (2, 4, 7, 8, 11) which correspond at least substantially to the layers formed on the upper surface and are at least substantially arranged congruently therewith,

— each of the two waveguides also incorporate the layers (2, 4, 7, 8, 11) on the bottom side of the substrate (1) which are arranged congruently with the layers (3, 5, 6, 9, 10) on the upper surface,

— a third waveguide is formed from the layers (8, 9) on the top and bottom surfaces which form the central line portions of the second waveguide, and

— always two of the mixing elements (12 to 15) are so provided on each side of the substrate (1) that they connect one of the centre layers (8, 9) to a portion of the remaining layers (2 to 7, 10, 11).

2. A mixer as claimed in claim 1, characterized in that the portions (2 to 5) of the layers which form the conductive portions of the first waveguide and the outermost portions (6, 7, 10, 11) of the layers of the second waveguide which portions are arranged next to each other on the same face of the dielectric substrate (1) consist of one piece.

3. A mixer as claimed in claim 1, characterized in that the substrate (1) which is made of a dielectric material is provided in an electrically conducting casing (30).

4. A mixer as claimed in claim 1, characterized in that the first waveguide is in the form of a slot or fineline and the second waveguide is in the form of a coplaner line.

5. A mixer as claimed in claim 1, characterized in that, for a transfer of high-frequency signals the second waveguide is connected to a first rectangular hollow waveguide (31, 83) in such manner that the second waveguide is inserted as a rod in the central plane of the hollow waveguide (31, 83) which extends parallel to the smaller cross-sectional dimension.

6. A mixer as claimed in claim 5, characterized in that the third waveguide comprises a cut-off filter (35 to 83) arranged on that side of the hollow waveguide (31, 38) which faces away from the mixing element.

7. A mixer as claimed in claim 6, characterized in that the cut-off filter (35 to 38) is formed by a section of a coplaner line arrangement formed from conductive layers on the dielectric substrate (1).

8. A mixer as claimed in claim 4, characterized in that the parallel plate line is transferred to an asymmetrical strip line by widening one of its conductors (39).

9. A mixer as claimed in claim 8, characterized in that the parallel plate line is connected to a coaxial line (33) via the asymmetrical strip line in such a manner that the non-widened conductor is connected to the central conductor (40) of the coaxial line (33) and the widened conductor is connected to the outermost conductor (41) of the coaxial line (33).

10. A mixer as claimed in claim 3, characterized in that the casing (30) is divided along the plane of the dielectric substrate (1) and the substrate (1) is secured between the portions (301, 302) of the casing (30) by clamping.

11. A mixer as claimed in claims 3 and 4, characterized in that the first waveguide is connected to a second rectangular hollow waveguide (32) in a junction formed by widening the slot between the portions (2 to 5) of the conductive layers and that the casing (30) is in the form of a rectangular hollow waveguide at least in the region of this junction.

12. A mixer as claimed in claims 3 and 4, characterized in that the parallel plate line (8, 9) is connected in a junction which is in the form of an anti-podal slot or fine-line with widening intermediate space between the layers (8, 9) to a third rectangular hollow waveguide and that the casing (30) is in the form of a rectangular hollow waveguide at least in the region of this junction.

13. A mixer as claimed in claim 3, characterized in that portions (2, 3; 4, 5; 6, 7; 10, 11) of the conductive layers arranged on both sides along the dielectric substrate (1) edges bordering on the casing (30), are electrically interconnected by the casing (30).

14. A mixer as claimed in claim 3, characterized in that at least some of the portions (2, 3; 4, 5; 6, 7; 10, 11) of the conductive layers arranged on both sides along the dielectric substrate (1) edges bordering on the casing (30) are electrically insulated from the casing (30) and provided with conductors (51) which are insulated from the casing (30) and all the further portions of the conductive layers for applying a d. c. bias voltage to one or several of the mixing elements (12 to 15).

15. A mixer as claimed in claims 4 and 14, characterized in that to keep the d. c. bias voltage removed from the waveguides connected to the parallel plate line (8, 9) the conductors of the parallel plate line are interrupted (64) and the points of the interruptions are shunted by coupling capacitances (61).

16. A mixer as claimed in claim 1, characterized in that the mixing elements (12 to 15) have a nonlinear effective resistance.

17. A mixer as claimed in claim 1, characterized in that the mixing elements (12 to 15) have a nonlinear reactance.

18. A mixer as claimed in claim 1, characterized in that the mixing elements (12 to 15) are in the form of diodes.

19. A mixer as claimed in claim 1, characterized in that a receiving signal whose frequency is to be converted is applied via the first waveguide and a pumping signal via the second waveguide to the mixing elements (12 to 15) and that an intermediate frequency signal formed in the mixing elements (12 to 15) is taken from the mixing elements (12 to 15) via the third waveguide.

20. A mixer as claimed in one or more of the preceding claims, characterized in that the mixing elements (12 to 15) and optionally the coupling capacitors (61 to 63) are beam-lead components.

21. A mixer as claimed in claim 19, characterized in that two mixing elements (13, 14) connect the centre layer (9) on the upper surface of the substrate (1) to one of the portions (3, 5) of the layers of the first waveguide on the upper surface and two further mixing elements (12, 15) connect the centre layer (8) on the bottom side of the substrate (1) to one of the portions (2, 4) of the layers of the third waveguide on the bottom side directly at the junctions of the waveguides.

**Revendications**

1. Mélangeur destiné, en particulier, à fonctionner dans le domaine des micro-ondes et des ondes millimétriques, comportant quatre éléments mélangeurs bipolaires (12 à 15) formant essentiellement une boucle, qui sont implantés dans la région d'un endroit de jonction d'au moins deux guides d'ondes (2 à 5, 6 à 11), dont un premier (2 à 5) comprend une structure conductrice formant une fente et le second, une structure conductrice constituée d'au moins une partie conductrice médiane et une partie conductrice extérieure (6, 10) disposée autour de la première, au moins les parties conductrices du premier guide d'ondes (3, 5) et la partie conductrice médiane (9) du deuxième guide d'ondes (6 à 11) étant déposées sous forme de revêtements sur la face supérieure d'un substrat (1) en forme de plaque en matière diélectrique, caractérisé en ce que:
– le substrat (1) est pourvu, sur sa face inférieure, de revêtements conducteurs (2, 4, 7, 8, 11) qui sont formés au moins à peu près en correspondance avec les revêtements prévus sur la face supérieure et sont diposés au moins en substance en coïncidence avec ceux-ci,
– chacun des deux guides d'ondes comprend également les revêtements (2, 4, 7, 8, 11) appliqués sur la face inférieure du substrat (1) en coïncidence avec les revêtements (3, 5, 6, 9, 10) situés sur la face supérieure,
– un troisième guide d'ondes est formé des revêtements (8, 9) sur les faces supérieure et inférieure, qui forment les parties conductrices médianes du deuxième guide d'ondes, et
– chaque fois deux des éléments mélangeurs (12 à 15) sur chaque face du substrat (1) sont disposés de manière à connecter chaque fois un des revêtements médians (8, 9) à une des parties des autres revêtements (2 à 7, 10, 11).

2. Mélangeur suivant la revendication 1, caractérisé en ce que les parties (2 à 5) des revêtements formant les parties conductrices du premier guide d'ondes, et les parties extérieures (6, 7, 10, 11) des revêtements du deuxième guide d'ondes disposées à proximité sur la même face du substrat diélectrique (1), sont réalisées d'une seule pièce.

3. Mélangeur suivant la revendication 1, caractérisé en ce que le substrat (1) en matière diélectrique est disposé dans un boîtier conducteur électrique (30).

4. Mélangeur suivant la revendication 1, caractérisé en ce que le premier guide d'ondes a la forme d'une ligne à fente ou à ailettes et le deuxième guide d'ondes a la forme d'une ligne coplanaire.

5. Mélangeur suivant la revendication 1, caractérisé en ce que le deuxième guide d'ondes, en vue du transfert de signaux de haute fréquence est connecté à un premier guide creux rectangulaire (31, 83) d'une manière telle que le deuxième guide d'ondes soit guidé à la manière d'un montant dans le plan médian du guide creux (31, 83) parallèle à sa petite dimension en coupe.

6. Mélangeur suivant la revendication 5, caractérisé en ce que le troisième guide d'ondes est pouvu d'un filtre d'arrêt (35 à 38) du côté du guide creux (31, 83) qui est éloigné des éléments mélangeurs.

7. Mélangeur suivant la revendication 6, caractérisé en ce que le filtre d'arrêt (35 à 38) est constitué d'une section d'un montage de ligne coplanaire qui est formée de revêtements conducteurs du substrat diélectrique (1).

8. Mélangeur suivant la revendication 4, caractérisé en ce que la ligne à plaques parallèles se fond dans une ligne à ruban asymétrique par évasement d'un de ses conducteurs (39).

9. Mélangeur suivant la revendication 8, caractérisé en ce que la ligne à plaques parallèles est connectée, par l'intermédiaire de la ligne à ruban asymétrique, à une ligne coaxiale (33) d'une manière telle que le conducteur qui ne s'évase pas soit connecté au conducteur central (40) de la ligne coaxiale (33) et que le conducteur qui s'évase soit connecté au conducteur extérieur (41) de la ligne coaxiale (33).

10. Mélangeur suivant la revendication 3, caractérisé en ce que le boîtier (30) est divisé le long du plan du substrat diélectrique (1) et ce substrat (1) est maintenu par serrage entre les parties (301, 302) du boîtier (30).

11. Mélangeur suivant les revendications 3 et 4, caractérisé en ce que le premier guide d'ondes est connecté, dans une transition formée par l'évasement de la fente entre les parties (2 à 5) des revêtements, à un deuxième guide creux rectangulaire (32) et que le boîtier (30) a la forme d'un guide creux rectangulaire au moins dans la zone de cette transition.

12. Mélangeur suivant les revendications 3 et 4, caractérisé en ce que la ligne à plaques parallèles (8, 9) est connectée, dans une transition qui est réalisée sous la forme d'une ligne à fente ou à ailettes énantiomorphes à espace évasé entre les revêtements (8, 9), à un troisième guide creux rectangulaire et que le boîtier (30) a la forme d'un guide creux rectangulaire au moins dans la zone de cette transition.

13. Mélangeur suivant la revendication 3, caractérisé en ce que des parties (2, 3; 4, 5; 6, 7; 10, 11) des revêtements conducteurs, qui sont disposées des deux côtés le long de bords du substrat diélectrique (1) adjacents au boîtier (30), sont interconnectées électriquement par le boîtier (30).

14. Mélangeur suivant la revendication 3, caractérisé en ce qu'au moins certaines des parties (2, 3; 4, 5; 6, 7; 10, 11) des revêtements conducteurs, qui sont disposées des deux côtés le long de bords du substrat diélectrique (1) adjacents au boîtier (30), sont isolées électriquement par rapport au boîtier (30) et sont pourvues d'amenées (51) isolées par rapport au boîtier (30) et par rapport à toutes les autres parties des revêtements conducteurs, pour l'application d'une tension de polarisation continue à un ou plusieurs des éléments mélangeurs (12 à 15).

15. Mélangeur suivant les revendications 4 et 14, caractérisé en ce que pour préserver la tension de polarisation continue des guides d'ondes connectés à la ligne à plaques parallèles (8, 9), les conducteurs de la ligne à plaques parallèles sont interrompus (64) et les endroits d'interruption sont pontés par des capacités de couplage (61).

16. Mélangeur suivant la revendication 1, caractérisé en ce que les éléments mélangeurs (12 à 15) présentent une résistance effective non linéaire.

17. Mélangeur suivant la revendication 1, caractérisé en ce que les éléments mélangeurs (12 à 15) présentent une réactance non linéaire.

18. Mélangeur suivant la revendication 1, caractérisé en ce que les éléments mélangeurs (12 à 15) ont la forme de diodes.

19. Mélangeur suivant la revendication 1, caractérisé en ce qu'un signal de réception à convertir en fréquence est amené aux éléments mélangeurs (12 à 15) par l'intermédiaire du premier guide d'ondes et un signal de pompage y est amené par l'intermédiaire du deuxième guide d'ondes, et qu'un signal de fréquence intermédiaire formé dans les éléments mélangeurs (12 à 15) est dérivé de ces éléments mélangeurs (12 à 15) par l'intermédiaire du troisième guide d'ondes.

20. Mélangeur suivant l'une quelconque des revendications précédentes, caractérisé en ce que les éléments mélangeurs (12 à 15) et, le cas échéant, les capacités de couplage (61 à 63) sont des composants «beam-lead».

21. Mélangeur suivant la revendication 19, caractérisé en ce que deux éléments mélangeurs (13, 14) connectent le revêtement médian (9) situé sur la face supérieure du substrat (1), chaque fois à une des parties (3, 5) des revêtements du premier guide d'ondes situés sur la face supérieure et deux autres éléments mélangeurs (12, 15) connectent le revêtement médian (8) situé sur la face inférieure du substrat (1) chaque fois à une des parties (2, 4) des revêtements du premier guide d'ondes situés sur la face inférieure, directement au niveau de l'endroit de jonction des guides d'ondes.

FIG.1

FIG.2

**F I G. 3**

**F I G. 4**

FIG.5

FIG.6

FIG.7